# EUROPÄISCHE PATENTSCHRIFT

(11) **EP 1 653 238 B1**
(45) Veröffentlichungstag und Bekanntmachung des Hinweises auf die Patenterteilung: **02.01.2008**
(21) Anmeldenummer: 04028340.0
(22) Anmeldetag: 30.11.2004
(51) Int. Cl.: G01R 31/06

(54) **Verfahren und Vorrichtung zur Bestimmung von nominellen Transformatorkenndaten**
Method and apparatus to determine nominal transformer parameters
Procédé et dispositif pour déterminer les paramètres nominales d'un transformateur

(30) Priorität: 26.10.2004 EP 04025403
(43) Veröffentlichungstag der Anmeldung: 03.05.2006
(73) Patentinhaber: Omicron electronics GmbH, 6833 Klaus (AT)
(72) Erfinder: Krüger, Michael Dr., 6844 Altach (AT); Süss, Franz, 6805 Feldkirch-Gisingen (AT)
(74) Vertreter: Banzer, Hans-Jörg

(56) Entgegenhaltungen:
- EP-A- 0 383 140
- EP-A- 1 398 644
- US-A- 4 654 806
- LUJAN W O: "The role of test methods and specifications in coil winding" ELECTRICAL INSULATION CONFERENCE, 1997, AND ELECTRICAL MANUFACTURING & COIL WINDING CONFERENCE. PROCEEDINGS ROSEMONT, IL, USA 22-25 SEPT. 1997, NEW YORK, NY, USA,IEEE, US, 22. September 1997 (1997-09-22), Seiten 627-640, XP010265772 ISBN: 0-7803-3959-2

## Beschreibung

Die vorliegende Erfindung betrifft ein Verfahren und eine Vorrichtung zur Bestimmung von nominellen Transformatordaten. Unter nominellen Transformatordaten werden dabei Transformatordaten verstanden, welche von einem Typ des Transformators abhängen und diesen kennzeichnen, beispielsweise ein Nennwert einer Stromstärke in einer Sekundärwicklung eines Transformators oder ein nominelles Übersetzungsverhältnis des Transformators. Die Erfindung kann insbesondere zur Identifizierung von Stromwandlern eingesetzt werden, ist jedoch auf andere Typen von Transformatoren wie beispielsweise Spannungswandler anwendbar.

Stromwandler sind nach verschiedenen Standards genormt, beispielsweise gemäß IEC 60044-1 oder IEC 60044-6. Derartige Stromwandler weisen zudem im Allgemeinen ein Typenschild auf, auf welchem nominelle Transformatordaten, beispielsweise ein Nennstrom der Sekundärwicklung oder Daten, welche ein Verhalten bei Überschreiten des Nennstroms kennzeichnen, umfassen. Zudem ist üblicherweise eine Klassenbezeichnung angegeben, aus welcher auf weitere Eigenschaften des Stromwandlers, beispielsweise Hystereseeigenschaften, geschlossen werden kann. Ähnliches gilt für andere Transformatoren wie beispielsweise Spannungswandler.

Aus der DE 100 48 962 A1 und EP 1 398 644 A1 sind Verfahren und Vorrichtungen zum Testen von Transformatoren, insbesondere mobile Vorrichtungen, bekannt, mit welchen elektrische Eigenschaften wie beispielsweise ein Widerstand einer Sekundärwicklung eines Stromwandlers bestimmt werden können. Hierdurch kann überprüft werden, ob ein Transformator durch einen jeweiligen Standard vorgegebenen Anforderungen entspricht. Dabei kann insbesondere bei älteren Transformatoren das Problem auftreten, dass das Typenschild des jeweiligen Transformators verlorengegangen oder teilweise unleserlich ist. Somit ist der genaue Typ des Transformators nicht bekannt, und ein sinnvolles Testen des jeweiligen Transformators ist erschwert. Ein Ableiten des Typs des Transformators bzw. von entsprechenden nominellen Transformatorkenndaten aus üblicherweise vorgenommenen Messungen ist auch für Fachleute schwierig.

Es ist daher eine Aufgabe der vorliegenden Erfindung, ein Verfahren und eine Vorrichtung zur Bestimmung von nominellen Transformatorkenndaten bereitzustellen, wodurch es möglich ist, aus elektrischen Messungen am Transformator einen Typ bzw. eine Klasse des Transformators oder zumindest die interessierenden Transformatorkenndaten zu bestimmen. Bevorzugt soll ein derartiges Verfahren und eine derartige Vorrichtung insbesondere mit bekannten Verfahren und Vorrichtungen zum Testen bzw. Prüfen von Transformatoren in mobilen bzw. tragbaren Einheiten kombinierbar sein.

Diese Aufgaben werden gelöst durch ein Verfahren gemäß Anspruch 1 und eine Vorrichtung gemäß Anspruch 17. Die abhängigen Ansprüche definieren jeweils bevorzugte oder vorteilhafte Ausführungsbeispiele. Zudem wird ein Computerprogramm-Produkt bereitgestellt, welches insbesondere zur Steuerung einer Prüfeinheit für Transformatoren dienen kann.

Erfindungsgemäß wird zur Bestimmung von nominellen Transformatorkenndaten eines Transformators vorgeschlagen, mindestens eine elektrische Eigenschaft des Transformators zu messen, und abhängig von der gemessenen elektrischen Eigenschaft, insbesondere abhängig von einem Vergleich der gemessenen elektrischen Eigenschaft mit mindestens einem vorgegebenen Schwellenwert, ein nominelles Transformatorkenndatum aus einer vorgegebenen Menge von möglichen nominellen Transformatorkenndaten auszuwählen. Die Erfindung macht sich also die Erkenntnis zunutze, dass es nur eine begrenzte Anzahl von Typen von Transformatoren mit jeweiligen nominellen Transformatorkenndaten gibt, wodurch es möglich ist, durch Messung von elektrischen Eigenschaften des Transformators ein oder mehrere nominelle Transformatorkenndaten mit hoher Sicherheit zu bestimmen.

Der mindestens eine vorgegebene Schwellenwert und/oder die vorgegebene Menge von möglichen nominellen Transformatorkenndaten kann dabei beispielsweise auf Basis eines Standards für Transformatoren bestimmt werden oder aus einer Menge von abgespeicherten nominellen Transformatorkenndaten hergeleitet werden.

Dabei kann ein Teil von nominellen Transformatorkenndaten des jeweiligen Transformators von einem Benutzer vorgegeben werden, und nur nicht vorgegebene nominelle Transformatorkenndaten bestimmt werden. Dies ermöglicht es, unbekannte nominelle Transformatorkenndaten genauer zu bestimmen, falls einige nominelle Transformatorkenndaten, beispielsweise bei einem nur teilweise lesbaren Typenschild, bekannt sind.

Die Erfindung eignet sich insbesondere zur Bestimmung von nominellen Transformatorkenndaten von Stromwandlern.

Dabei kann beispielsweise die mindestens eine elektrische Eigenschaft einen Widerstand einer Sekundärwicklung des Stromwandlers umfassen. Durch Vergleich dieses Widerstandes der Sekundärwicklung mit einem oder mehreren vorgegebenen Schwellenwerten kann ein Nennwert für einen Sekundärstrom des Stromwandlers ermittelt werden. Zudem kann die mindestens eine elektrische Eigenschaft eine Spannung bei einem Kniepunkt des Stromwandlers umfassen. Abhängig von der Spannung am Kniepunkt kann dann bestimmt werden, ob es sich um einen so genannten Messwandler oder einen so genannten Schutzwandler handelt. Des Weiteren kann ein Überstromverhalten als nominelles Transformatorkenndatum bestimmt werden.

Schließlich kann die mindestens eine elektrische Eigenschaft auch ein Wicklungsverhältnis des Transformators sein, woraus insbesondere unter Kenntnis des Nennstroms in der Sekundärwicklung ein Nennstrom in einer Primärwicklung des Transformators sowie ein Fehlerwert bestimmt werden kann.

Die Erfindung wird im Folgenden unter Bezugnahme auf die beigefügte Zeichnung anhand bevorzugter Ausführungsbeispiele näher erläutert. Es zeigen:
Fig. 1 ein Blockschaltbild einer erfindungsgemäßen Vorrichtung zur Bestimmung von nominellen Transformatorkenndaten eines Transformators,
Fig. 2 eine Anregungskurve eines Transformators zur Bestimmung eines Kniepunktes,
Fig. 3 ein erstes Flussdiagramm eines erfindungsgemäßen Verfahrens zum Bestimmen von nominellen Kenndaten eines Stromwandlers,
Fig. 4 ein zweites Flussdiagramm eines weiteren erfindungsgemäßen Verfahrens zur Bestimmung von nominellen Kenndaten eines Stromwandlers,
Fig. 5 ein drittes Flussdiagramm eines erfindungsgemäßen Verfahrens zur Bestimmung von nominellen Kenndaten von Stromwandlern nach dem IEC 60044-6-Standard, und
Fig. 6 ein viertes Flussdiagramm eines weiteren erfindungsgemäßen Verfahrens.

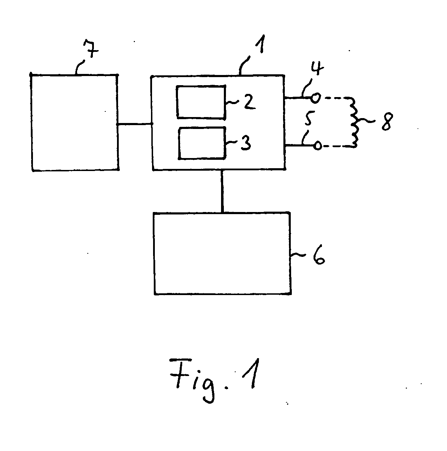

In Fig. 1 ist ein Ausführungsbeispiel einer erfindungsgemäßen Vorrichtung zur Bestimmung von nominellen Transformatordaten gezeigt. Dabei umfasst die erfindungsgemäße Vorrichtung eine Messeinrichtung 1 mit Messanschlüssen 4 und 5, an welche ein zu vermessender Transformator, beispielsweise eine Sekundärwicklung 8 eines Stromwandlers, angeschlossen wird. Selbstverständlich ist die Anzahl der Messanschlüsse nicht auf zwei beschränkt. Beispielsweise können auch vier Anschlussklemmen vorhanden sein, um z.B. bei Stromwandlern, welche zwei Sekundärwicklungen aufweisen, beide Sekundärwicklungen getrennt zu vermessen, oder um sowohl eine Primär- als auch eine Sekundärwicklung anzuschließen. Zu bemerken ist, dass Messungen an dem Transformator im Allgemeinen als Vierpunktmessungen durchgeführt werden. Hierzu kann die Messeinrichtung 1 ebenfalls die erforderliche Anzahl von Messanschlüssen 4, 5 aufweisen. Beispielsweise kann dann jeder der zwei Anschlüsse der Sekundärwicklung mit zwei Messanschlüssen der Messeinrichtung 1 verbunden sein, wobei über jeweils einen der jeweiligen zwei Messanschlüsse ein Strom in die Sekundärwicklung 8 eingeprägt wird und über die jeweils anderen der jeweiligen zwei Messanschlüsse ein entsprechender Spannungsabfall gemessen wird. Es ist in diesem Fall jedoch auch möglich, insgesamt nur zwei Messanschlüsse an der Messeinrichtung 1 vorzusehen und die "Umsetzung" auf die für eine Vierpunktmessung notwendigen vier Messleitungen erst innerhalb der Messeinrichtung 1 vorzunehmen.

Die Messeinrichtung 1 umfasst Messmittel 2 zur Erzeugung von Messströmen, Messspannungen sowie zum Messen entsprechender Ströme, Spannungen und dergleichen. Des Weiteren umfasst die Messeinrichtung 1 einen digitalen Signalprozessor 3 zum Auswerten der Messungen sowie zur Erzeugung digitaler Messsignale. Derartige Messeinrichtungen sind in den eingangs zitierten Druckschriften DE 100 48 962 A1 und EP 1 398 644 A1 näher erläutert. In diesen Druckschriften finden sich auch nähere Informationen, wie bestimmte, im Folgenden verwendete Messwerte elektrischer Eigenschaften bestimmt werden können.

Die erfindungsgemäße Vorrichtung umfasst weiterhin eine Speichereinrichtung 6. In dieser Speichereinrichtung sind Daten über verfügbare Transformatoren, Daten bezüglich Standards für Transformatoren sowie Daten für Algorithmen zum Bestimmen von nominellen Transformatorkenndaten, welche in den nachfolgend beschriebenen Verfahren verwendet werden, gespeichert. Der digitale Signalprozessor 3 benutzt die in der Speichereinrichtung 6 gespeicherten Daten, um nominelle Transformatorkenndaten eines an den Anschlussklemmen 4, 5 angeschlossenen Transformators zu bestimmen. Diese Daten werden dann auf einer Anzeigeeinheit 7 ausgegeben. Die Anzeigeeinheit 7 kann dabei ein beliebiges Display sein, es sind aber auch andere Arten der Anzeige, beispielsweise ein Ausdrucken der entsprechend ermittelten nominellen Transformatorkenndaten oder auch eine Sprachansage denkbar.

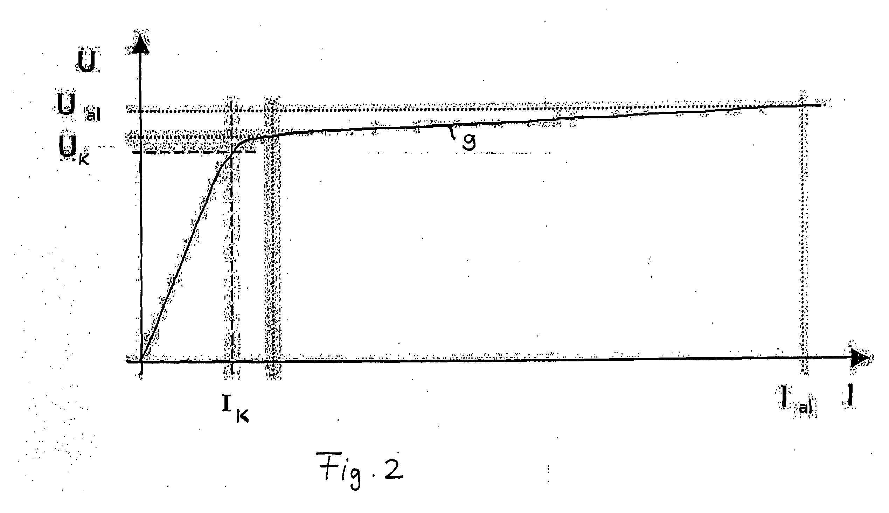

Als Beispiel für eine von der Messeinrichtung 1 aus Fig. 1 durchgeführte Messung ist in Fig. 2 eine so genannte Anregungskurve ("Excitation Curve") einer Sekundärspule eines Stromwandlers gezeigt. Zur Aufnahme der Anregungskurve 9 wird abhängig von einem in die Sekundärspule bei einer geeigneten Frequenz eingeprägten Strom I ein entsprechender Spannungsabfall U gemessen. Dabei werden I und entsprechend U bis zu vorgegebenen Grenzwerten (Accuracy Limit) Iₐₗ bzw. Uₐₗ und darüber hinaus gemessen. Der Strom I bzw. die Spannung U können dabei sowohl als Effektivwert bzw. quadratischer Mittelwert (RMS, Root Mean Square) als auch als Spitzenwert angegeben werden. Welcher Wert üblicherweise benutzt wird, hängt von der Art des jeweiligen Stromwandlers ab. Beispielsweise wird für so genannte Klasse P-Stromwandler üblicherweise ein Mittelwert angegeben, während für Klasse TP-Stromwandler der Spitzenwert angegeben wird.

Kurve 9 lässt sich in zwei Bereiche unterteilen, einen Bereich großer Steigung bei kleinen Strömen und einen Bereich kleiner Steigung bei großen Strömen. Der Übergang zwischen diesen beiden Bereichen, welcher von dem jeweiligen Stromwandler abhängt, wird durch den so genannten Kniepunkt mit einem Kniestrom I_{K} und einer Kniespannung U_{K} gekennzeichnet. Nach IEC-Standard ist der Kniepunkt als derjenige Punkt definiert, bei welchem ein Spannungsanstieg um 10% einen Stromanstieg um 50% hervorruft. Nach ANSI-Standard ist der Kniepunkt derjenige Punkt, bei welchem die Tangente an die Kurve 9 in doppelt logarithmischer Darstellung einen Winkel von 45° aufweist, also parallel zur Winkelhalbierenden ist. Auch wenn diese Definitionen nicht zu identischen Werten für U_{K} und I_{K} führen, eignen sie sich doch gleichermaßen zur Charakterisierung der Änderung des Verhaltens der Kurve 9.

Aus der Anregungskurve 9 kann zudem eine ungesättigte Induktivität L_{U}, welche der Steigung der Kurve 9 für I<I_{K}, geteilt durch 2nf, wobei f die Anregungsfrequenz ist, entspricht, und eine gesättigte Induktivität Lₛ, bei welcher entsprechend die Steigung für I>>I_{K} verwendet wird, definiert werden.

Generell können Stromwandler in zwei Gruppen eingeteilt werden: Messwandler und Schutzwandler. Im Englischen wird hier auch von "Measuring Cores" und "Protection Cores", bezogen auf die Eisenkerne (Cores) der Wandler, gesprochen. Messwandler werden zum Messen hoher Ströme eingesetzt, wobei die Messwandler einen hohen in einer Leitung vorliegenden Strom in einen niedrigeren, leichter messbaren Strom umsetzen. Entsprechend ist bei Messwandlern eine hohe Messgenauigkeit, d.h. eine geringe Abweichung von einem nominellen Untersetzungsverhältnis, und eine kleinere Phasenverschiebung wichtig. Eine Sättigungsspannung des Wandlers sollte klein sein, um bei hohen Strömen, welche beispielsweise durch einen Kurzschluss hervorgerufen werden, einen Schutz von Messgeräten zu gewährleisten. Wichtige Parameter sind hier eine nominelle Bürde bzw. Last ("Burden") und das Übersetzungsverhältnis.

Bei Schutzwandlern ist im Gegensatz dazu die Genauigkeit weniger wichtig. Schutzwandler dienen beispielsweise zur Ansteuerung von Schutzrelais. Hier ist ein hoher Überstromfaktor wichtig, d.h. hier soll die Sättigung erst spät eintreten.

Derartige Stromwandler sind nach verschiedenen Standards genormt. Insbesondere sind hier der IEC 60044-1-Standard, der IEC 60044-6-Standard sowie der ANSI 57.13 (IEEE C57.13)-Standard zu nennen. Insbesondere definiert der IEC 60044-1-Standard Schutzwandler mit den Kennungen P, PR, PX, wobei P jeweils für Protection, R für eine niedrige Remanenz und X für eine niedrige Leckinduktivität steht. Messwandler werden hingegen mit M bezeichnet.

IEC 60044-6 definiert hingegen Schutzwandler, welche durch ihr Transientenverhalten gekennzeichnet sind (allgemeine Kennung TP). So ist beispielsweise bei Stromwandlern vom Typ TPX eine Grenze für den maximalen Fehler des momentanen Sekundärstroms während einer definierten Stromsequenz vorgegeben, während keine Grenze für den remanenten Fluss vorgegeben ist. Bei Stromwandlern des Typs bzw. der Klasse TPY ist ebenfalls ein Grenzwert für den maximalen Fehler des momentanen Sekundärstroms in dem Stromwandler vorgegeben. Zusätzlich muss der remanente Fluss kleiner als 10% des Sättigungsflusses sein. Klasse TPZ gibt schließlich einen Grenzwert für den Fehler der Wechselstromkomponente des Sekundärstroms während eines Stromflusses mit maximaler Gleichstromverschiebung und einer definierten Zeitkonstante des Sekundärkreises des Stromwandlers vor, während für einen Fehler einer Gleichstromkomponente keine Grenze vorgegeben ist. In diesem Fall muss der remanente Fluss vernachlässigbar sein. Eine weitere Klasse ist mit TPS bezeichnet. Bezüglich der genauen Definition ist auf die genannten Standards zu verweisen.

Des Weiteren zeichnen sich Stromwandler durch vorgegebene Nennströme im Sekundär- bzw. im Primärkreis, durch vorgegebene Übersetzungsverhältnisse und andere nominelle Transformatorkenndaten aus. Beispielsweise sind für den Nennwert des Sekundärstroms 1 A und 5 A gebräuchlich bzw. im Handel erhältlich. Diese Werte sind üblicherweise auf einem Typenschild auf dem Stromwandler vermerkt.

Mittels der erfindungsgemäßen Vorrichtung aus Fig. 1 und den nachfolgend beschriebenen erfindungsgemäßen Verfahren ist es nun möglich, diese Kenndaten festzustellen, falls das Typenschild unleserlich oder nicht vorhanden ist.

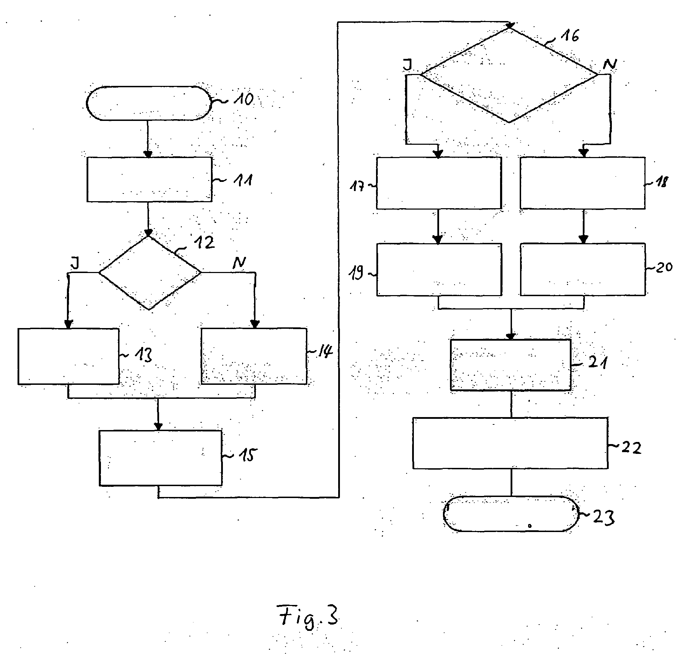

In Fig. 3 ist dazu ein Flussdiagramm eines Verfahrens zur Bestimmung von nominellen Kenndaten eines Stromwandlers dargestellt, welches insbesondere auf Stromwandler nach IEC 60044-1 anwendbar ist. Dabei ist von vorneherein nicht bekannt, ob es sich um einen Messwandler oder einen Schutzwandler handelt.

Das Verfahren wird in Schritt 10 gestartet. In Schritt 11 wird ein Widerstand der Sekundärwicklung des Stromwandlers bestimmt. Zu bemerken ist, dass der Widerstand üblicherweise bei 75°C gemessen wird. Dies kann beispielsweise durch Einprägen eines vorgegebenen Gleichstroms und gleichzeitiger Messung des Spannungsabfalls vorgenommen werden.

In Schritt 12 wird überprüft, ob der in Schritt 11 bestimmte Widerstand kleiner als 1 Ohm ist. Falls Ja (Zweig "J"), wird in Schritt 13 festgestellt, dass ein Nennwert des Sekundärstroms Isn=5A ist. Falls Nein (Zweig "N"), wird in Schritt 14 festgestellt, dass der Nennwert des Sekundärstroms Isn=1A ist. Hier wird also erfindungsgemäß ausgenutzt, dass zum einen im Wesentlichen nur zwei unterschiedliche Nennwerte für den Sekundärstrom, nämlich 1A und 5A, auftreten, und zum anderen von dem Nennwert der Wert des Widerstandes der Sekundärwicklung abhängt. Dabei ist zu beachten, dass der Grenzwert 1 Ohm in Schritt 12 derart gewählt wurde, dass der Nennwert mit hoher Wahrscheinlichkeit richtig erkannt wird. Es ist aber selbstverständlich auch möglich, einen von 1 Ohm abweichenden Schwellenwert, beispielsweise 1,1 Ohm, vorzugeben, oder einen Bereich um 1 Ohm herum vorzugeben, bei welchem ein Benutzer gewarnt wird, dass eine sichere Erkennung gegebenenfalls nicht möglich ist, da der gemessene Wert nahe am Grenzwert liegt. Bei Transformatoren, bei welchen mehr als zwei Nennwerte auftreten können, können auch entsprechend mehr Schwellenwerte vorgegeben werden.

In Schritt 15 wird dann die bereits unter Bezugnahme auf Fig. 2 diskutierte Anregungskurve des Stromwandlers gemessen. Hierdurch ergibt sich insbesondere zusammen mit der in Schritten 11-14 ermittelten Nennwert für den Sekundärstrom Isn eine diesem Nennwert zugeordnete Spannung und somit auch eine Nennleistung als Produkt aus dieser Spannung und dem Nennwert des Sekundärstroms Isn. Des Weiteren wird die Kniespannung U_{K} bzw. der Kniestrom I_{K} wie beschrieben ermittelt. In Schritt 16 wird überprüft, ob die Kniespannung kleiner ist als das Achtfache des Quotienten aus Nennleistung und Nennstrom, d.h. ob U_{K}<8×Psn/Isn gilt, wobei Psn die Nennleistung ist. Falls Ja, wird in Schritt 17 festgestellt, dass es sich um einen Messwandler handelt, falls Nein, wird in Schritt 18 festgestellt, dass es sich um einen Schutzwandler handelt. Hier wird ausgenutzt, dass Schutzwandler einen wesentlich größeren Linearitätsbereich und somit eine größere Kniespannung aufweisen als Messwandler. Anstatt des Schwellenwertes 8xPsn/Isn kann hier auch für jeden Nennstrom ein von der Nennleistung unabhängiger Schwellenwert vorgegeben werden, was jedoch im Allgemeinen zu einer ungenaueren Bestimmung der Art des Wandlers führt.

Wenn festgestellt wird, dass es sich um einen Messwandler handelt, wird in Schritt 19 der so genannte Überstromfaktor (FS-Faktor) bestimmt. Dieser gibt einen maximalen Anstieg der Spannung im Sekundärkreis der Sekundärspule bzw. -wicklung an, wenn eine Nennlast angeschlossen ist, und kann beispielsweise aus der Anregungskurve oder durch separate Messungen bestimmt werden. Für Schutzwandler wird in Schritt 20 der ALF-Faktor (Accuracy Limit Factor) bestimmt, welcher angibt, bis zum wievielfachen Nennstrom der Anstieg der Spannung im Sekundärkreis im Wesentlichen linear verläuft.

Sowohl in Schritt 19 als auch in Schritt 20 wird bevorzugt die Nennlast/Nennleistung verwendet. Ist diese nicht bekannt, kann die Bestimmung auch auf eine vorgegebene Nennlast, beispielsweise 15 VA, bezogen werden, was einem typischen Wert entspricht. (Die Nennlast wird üblicherweise als Scheinleistung bei dem Nennwert für den Sekundärstrom angegeben.)

Für beide Arten von Wandlern wird in Schritt 21 ein Übersetzungsverhältnis, welches von einem Wicklungsverhältnis zwischen Primärspule und Sekundärspule abhängt, gemessen. Hierzu kann beispielsweise an der Sekundärspule eine Spannung insbesondere eine Wechselspannung, angelegt werden und dann sowohl an der Sekundärspule als auch an der Primärspule die jeweils abfallende Spannung gemessen werden. Aus dem Verhältnis dieser Spannungen kann dann, gegebenenfalls unter Berücksichtigung weiterer Messungen wie einer Messung eines Magnetisierungsstroms, das Übersetzungsverhältnis bestimmt werden.

In Schritt 22 wird dann aus diesem gemessenen Übersetzungsverhältnis ein Nennwert für den Nennwert des Übersetzungsverhältnisses, ein entsprechender Fehler sowie ein Primärstrom bestimmt. Hierfür wird ausgenutzt, dass für den Nennwert des Übersetzungsverhältnises ebenfalls nur eine begrenzte Anzahl von Werten üblicherweise verwendet werden. Für den Primärstrom existiert bei kommerziell erhältlichen Stromwandlern nämlich nur eine begrenzte Menge an möglichen Nennwerten, insbesondere 10, 12, 12.5, 15, 20, 24, 25, 30, 36, 40, 48, 50, 60, 75 oder 80A. Zusammen mit den bereits diskutierten möglichen Nennwerten für den Sekundärstrom von 1A und 5A ergeben sich durch Division mögliche Nennwerte für das Übersetzungsverhältnis. Indem der in Schritten 11-14 ermittelte Nennwert für den Sekundärstrom also mit dem gemessenen Übersetzungsverhältnis multipliziert wird und dann überprüft wird, welchem Nennwert für den Primärstrom dieses Produkt am nächsten kommt, kann der Nennwert für den Primärstrom und aus diesem und dem Nennwert des Sekundärstroms wiederum der Nennwert für das Übersetzungsverhältnis bestimmt werden. Ein Fehlerwert ergibt sich dann aus der Abweichung zwischen gemessenen Übersetzungsverhältnis und bestimmten Nennwert für das Übersetzungsverhältnis.

Somit konnten wesentliche nominelle Kenndaten des Stromwandlers durch Messungen bestimmt werden. In Schritt 23 wird das Verfahren dann beendet, wobei anhand gespeicherter Typen bzw. Klassen von Stromwandlern und der ermittelten Werte auch ausgegeben werden kann, welche Klasse mit hoher Wahrscheinlichkeit vorliegt.

Zu bemerken ist dabei, dass neben den oben dargestellten Messungen auch weitere Messungen zur Bestimmung der nominellen Kenndaten durchgeführt werden können oder mehrere Messungen zur Bestimmung eines Kenndatums herangezogen werden können. Beispielsweise kann zur Bestimmung des Nennwertes des Sekundärstroms auch der Kniepunkt und das Übersetzungsverhältnis herangezogen werden, oder es können zusätzlich der in Schritt 12 bestimmte Widerstand und das Übersetzungsverhältnis ausgewertet werden, um zu bestimmen, ob der Wandler ein Schutzwandler oder ein Messwandler ist.

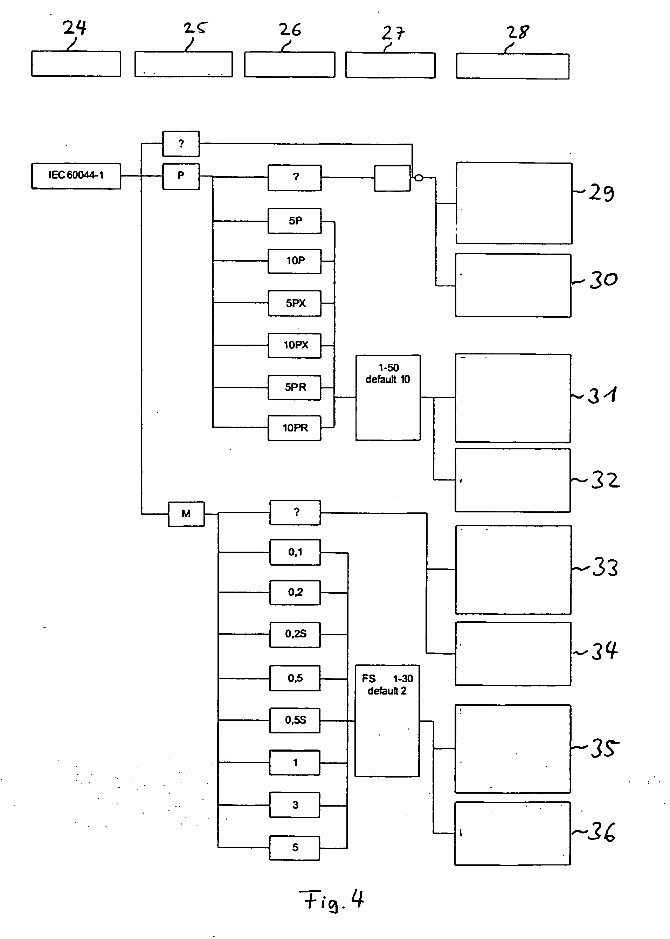

Prinzipiell ist es möglich, dass einzelne nominelle Transformatorkenndaten bekannt sind, während andere bestimmt werden müssen. Fig. 4 zeigt ein Flussdiagramm eines erfindungsgemäßen Verfahrens zur Bestimmung von nominellen Kenndaten von Stromwandlern nach IEC 60044-1, bei welchen Angaben von Benutzern berücksichtigt werden können. Dabei ist das Flussdiagramm aus Fig. 4 von links nach rechts zu lesen, wobei in der obersten Zeile Elemente 24-28 gleichsam Spaltenüberschriften darstellen, welche angeben, welcher Parameter in der darunter liegenden Spalte festgelegt wird.

Zunächst wird in Spalte 24 der Standard festgelegt, nach welchem geprüft werden soll, in diesem Fall IEC 60044-1. In Spalte 25 wird dann festgelegt bzw. von einem Benutzer eingegeben, ob es sich um einen Schutzwandler oder einen Messwandler handelt. Dabei bedeutet "?", dass die Art des Stromwandlers nicht bekannt ist, "P", dass es sich um einen Schutzwandler handelt, und "M", dass es sich um einen Messwandler handelt. Ist schon die Art des Wandlers nicht bekannt (Eingabe "?"), so werden die folgenden Spalten 26 und 27, in welchen die Klasse des Wandlers genauer spezifiziert werden kann, übersprungen.

In Spalte 26 kann dann die genaue Klasse des jeweiligen Wandlers eingegeben werden. Ein "?" bedeutet wiederum, dass diese nicht bekannt ist und falls möglich durch die Vorrichtung aus Fig. 1 bestimmt werden soll. Bei den Schutzwandlern ergeben sich hier die möglichen Klassen 5P, 10P, 5PX, 10PX, 5PR und 10PR, wobei die Bedeutung der Buchstaben P, PX und PR bereits erläutert wurde. Die dem oder den Buchstaben vorangestellte Zahl ist eine maximale Abweichung von linearem Verhalten bei einem Strom, welcher den mit dem ALF-Faktor multiplizierten Nennstrom ergibt, von einem bei streng linearem Verhalten zu erwartenden Wert. Üblich sind hier 5 für 5% Abweichung und 10 für 10% Abweichung.

Auch bei den Messwandlern bedeutet "?", dass der Benutzer die Klasse nicht kennt. Klassenbezeichnungen sind hier 0,1; 0,2; 0,2S; 0,5; 0,5S; 1; 3 und 5. Für diese Klassen ist gemäß dem IEC 60044-1-Standard jeweils definiert, um wie viel ein tatsächlicher Strom von einem vorgegebenen Strom, welcher abhängig von dem Nennwert des Sekundärstroms vorgegeben ist, abweichen kann. Bei allen Klassen außer 3 und 5 ist zudem vorgegeben, wie groß ein Phasenfehler sein darf. Die genauen Werte hierfür sind dem angegebenen Standard zu entnehmen.

In Spalte 27 kann dann ein Verhalten des Stromwandlers bei Strömen oberhalb des Nennwertes für den Sekundärstrom festgelegt werden. Für Schutzwandler wird dies wie bereits erläutert durch den ALF-Faktor bestimmt. Dieser liegt in einem Bereich von 1-200, wobei 10 ein üblicher Wert ist, welcher dem Benutzer als Default-Wert angeboten wird. Zur Erleichterung der Eingabe können dem Benutzer hier beispielsweise so genannte "Soft Keys" angeboten werden, wodurch er beispielsweise durch Berührung eines Bildschirms an der entsprechenden Stelle auf einfache Weise ALF-Faktoren von 5, 10, 15, 20 und 30, welche besonders häufig sind, auswählen kann. In ähnlicher Weise kann für Messwandler der FS-Faktor, welcher zwischen 1 und 30 liegt, vorgegeben werden, auch hier können Soft Keys vorgegeben sein. In Spalte 28 werden dann alle Kenndaten, welche beispielsweise wie in Fig. 3 dargestellt bestimmt werden, und welche von der Messvorrichtung bewertet werden können, dargestellt. Unter Bewertung wird dabei die Feststellung verstanden, ob die Kenndaten des Wandlers die durch den jeweiligen Standard (z.B. IEC 60044-1) vorgegebenen Spezifikationen erfüllen. Insbesondere werden in Block 29 für den Fall, dass keine Vorgaben gemacht wurden oder nur vorgegeben wurde, dass es sich um einen Schutzwandler handelt, diejenigen Kenndaten wie der Kniepunkt (gemäß der IEC-Definition), der ALF-Faktor, die Anregungskurve, Kniespannung und Strom, Übersetzungsverhältnis, die Klasse des Wandlers, der Widerstand der Sekundärwicklung, gesättigte und ungesättigte Induktivität des Wandlers, eine Zeitkonstante Tₛ, welche dem Quotienten der gesättigten Induktivität, auch als Leckinduktivität bezeichnet, und dem Widerstand der Sekundärwicklung entspricht, sowie ein Remanenzfaktor Kᵥ bei der Magnetisierung dargestellt, welche beispielsweise durch die bereits erläuterten Messungen ermittelt werden, wobei die Bestimmung des letzteren durch Aufnahme einer Hysteresekurve erfolgen kann.

In Block 30 wird unabhängig davon dargestellt, welche Kenndaten bewertet werden, d.h. dargestellt, ob die ermittelten Kenndaten die vorgegebenen Kenndaten erfüllen. Da im Falle von Block 30 keine Kenndaten vorgegeben wurden (bzw. lediglich, ob der Wandler ein Schutzwandler oder ein Messwandler ist), werden auch keine Kenndaten bewertet.

Die Paare von Blöcken 31/32, 33/34 und 35/36 entsprechen den Blöcken 29 bzw. 30, wobei je nach Typ des Wandlers andere Kenndaten berechnet und dargestellt werden und je nach den von dem Benutzer eingegebenen Vorgaben entsprechende Kenndaten bewertet werden.

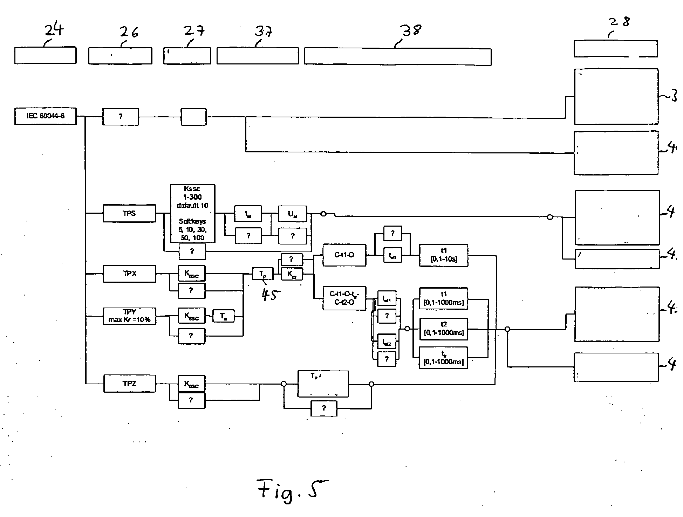

In Fig. 5 ist ein entsprechendes Flussdiagramm für Stromwandler nach dem IEC 60044-6-Standard, also für Schutzwandler, welche über ihr Transientenverhalten spezifiziert sind, dargestellt. Der prinzipielle Aufbau des Flussdiagramms von Fig. 5 entspricht dabei demjenigen von Fig. 4. Dabei bezeichnen gleiche Bezugszeichen Spalten, in welchen gleiche oder ähnliche Funktionen ausgeführt werden.

In Spalte 24 wird wie bei Fig. 4 der Standard festgelegt, in diesem Fall IEC 60044-6. Da es sich bei den Wandlern nach IEC 60044-6 stets um Schutzwandler handelt, entfällt Spalte 25 aus Fig. 4. In Spalte 26 wird dann die Klasse des Wandlers festgelegt, wobei "?" wiederum bedeutet, dass die Klasse des Wandlers nicht bekannt ist. Ansonsten können TPS, TPX, TPY (maximaler Remanenzfaktor Kr 10%) und TPZ vorgegeben werden. Ist die Klasse nicht bekannt, werden in Spalte 28 in Blöcken 39 und 40 die Messungen bzw. Berechnungen analog zu Block 29 und 30 aus Fig. 4 durchgeführt.

Wird hingegen eine der Klassen TPS, TPX, TPY oder TPZ vorgegeben, so wird in Spalte 27 ein so genannter Nennwert des symmetrischen Kurzschlussstromfaktors (Rated Symmetrical Short Circuit Current Factor) K_{ssc} vorgegeben, welcher als Verhältnis zwischen einem Nennwert des Kurzschlussstroms im Primärkreis zu einem Nennwert des Stroms im Primärkreis definiert ist, vorgegeben. Der Wert K_{ssc} entspricht im Wesentlichen dem ALF-Faktor bzw. dem FS-Faktor bei Stromwandlern nach IEC 60044-1 und liegt üblicherweise zwischen 1 und 300. Als Default-Wert kann einem Benutzer 10 vorgegeben werden, während durch die bereits erwähnten Soft Keys jeweils die typischen Werte 5, 10, 30, 50 und 100 vorgegeben werden können.

Der Benutzer kann jedoch auch jeweils eingeben, dass der K_{ssc-}Wert nicht bekannt ist ("?"). Bei Wandlern der Klasse TPY kann hier zusätzlich die Zeitkonstante Tₛ eingegeben werden. In Spalte 37 werden dann so genannte erweiterte Definitionen eingegeben, d.h. für den die jeweilige Klasse typische festgelegte Werte. Für Klasse TPS werden dabei Werte für Iₐₗ und Uₐₗ eingegeben bzw. eingegeben, dass diese Werte nicht bekannt sind (vgl. Fig. 2). Für Wandler der Klasse TPX und TPY wird ein Wert Tp eingegeben, welcher die Zeitkonstante der Gleichstromkomponente des Stroms im Primärkreis angibt. Falls dieser Wert, mit Bezugszeichen 45 gekennzeichnet, nicht eingegeben wird, wird der Benutzer darauf hingewiesen, dass in diesem Fall der Test entsprechend Fig. 4 durchgeführt werden muss. Des Weiteren kann ein Wert K_{dt} eingegeben werden, welcher ein transienter Bemessungs-Dimensionierungsfaktor ist und einen theoretischen Wert darstellt, welcher die nötige transiente Dimensionierung für ein spezifiziertes Arbeitszyklus ("Duty Cycle") darstellt. Diesbezüglich ist zu bemerken, dass, wenn nicht anders angegeben, die im Rahmen dieser Beschreibung, insbesondere bezüglich der Fig. 4-6, verwendeten Bezeichnungen mit denen der entsprechenden Standards übereinstimmen, so dass genauere Definitionen den entsprechenden Standards entnommen werden können. Ein Wert für Tp kann auch bei Wandlern der Klasse TPZ eingegeben werden, wobei es hier auch möglich ist, einzugeben, dass der Wert nicht bekannt ist.

In Spalte 38 können dann für Wandler der Klassen TPX und TPY typische Zeitdefinitionen eingegeben werden oder vorgegeben werden, dass diese nicht bekannt sind. Dabei ist zu beachten, dass die entsprechenden Schutzwandler in Schutzeinrichtungen mit einfacher Ausschaltung und Schutzeinrichtungen mit Wiedereinschaltung verwendet werden können. Ein Zweig C-t1-0 bezeichnet dabei Schutzeinrichtungen mit einfacher Ausschaltung, wobei C für geschlossenen Schalter (close) und O für offenen Schalter (open) steht, während t1 eine Zeitkonstante darstellt, welche angibt, nach welcher Zeit eine Abschaltung, d.h. ein Öffnen des Schalters, erfolgt, wenn ein bestimmtes Fehlereignis auftritt. Diese Zeit ist im IEC 60044-6-Standard als t' bezeichnet. Ein Zweig C-t1-O-t_{fr}-C-t2-O bezeichnet eine Schutzfunktion mit Wiedereinschaltung. Nach dem Öffnen des Schalters nach der Zeit t1 bezeichnet t_{fr} eine Wartezeit, nach welcher der Schalter automatisch wieder geschlossen wird. t2, in dem IEC 60044-6-Standard als t" bezeichnet, gibt dann die Zeit an, nach welcher bei einem vorgegebenen Fehler der Schalter entgültig geöffnet wird.

Im Falle von Schutzeinrichtungen mit einfacher Abschaltung kann neben der Zeitkonstante t1 eine Zeitkonstante tₐ₁₁ (im Standard: t'ₐ₁) vorgegeben werden oder angegeben werden, dass diese Zeitkonstante nicht bekannt ist. Diese Zeitkonstante gibt an, über welche Zeitdauer eine spezifizierte Genauigkeit während einer Periode eines Arbeitszyklus beibehalten wird. Entsprechend können für Schutzeinrichtungen mit Wiedereinschaltung neben den Zeitkonstanten t1, t2, t_{fr} Zeitkonstanten tₐₗ₁ und tₐₗ₂ angegeben werden bzw. angegeben werden, dass diese nicht bekannt sind (im Standard: t'ₐₗ bzw. t"ₐₗ), wobei diese Zeitkonstanten der Zeitkonstante tₐₗ₁ für Schutzeinrichtungen mit einfacher Abschaltung entsprechen, wobei tₐₗ₁ den ersten Abschaltvorgang und tₐₗ₂ den zweiten Abschaltvorgang betrifft.

Die Werte für die Zeitkonstanten t1, t2 und t_{fr} können beispielsweise zwischen 0,1 ms und 1000 ms liegen, wobei je nach Wandler auch größere oder kleinere Werte möglich sind.

Die Paare von Blöcken 39/40, 41/42 und 43/44 entsprechen wiederum den bereist beschriebenen Blöcken 29 und 30, wobei hier nun die für den IEC 60044-6-Standard relevanten Kenndaten bestimmt bzw. bewertet werden.

Für Wandler der Klassen TPX, TPY und TPZ wird in Block 43 zusätzlich zu den in Block 41 ausgegebenen Werten noch ein momentaner Spitzenfehler *ε̂*, welcher einen maximalen momentanen Fehlerstrom für einen bestimmten Arbeitszyklus in Prozent des momentanen Spitzenwertes des Nennkurzschlussstroms in Primärkreis angibt, der Wert Kdt und die Werte tₐ₁₁ und tₐ₁₂ angegeben. Zusätzlich kann eine Zeit angegeben werden, bis ein maximaler Fluss in den Wandler erreicht wird. Als Vorgaben werden in Block 44 die Werte K_{ssc}, gegebenenfalls die Werte K_{dt}, die Klasse, gegebenenfalls die Werte tₐ₁₁ und tₐ₁₂ sowie für Wandler der Klasse TPY noch der Wert Tₛ sowie die Tatsache, dass Kr<10% ist, angegeben.

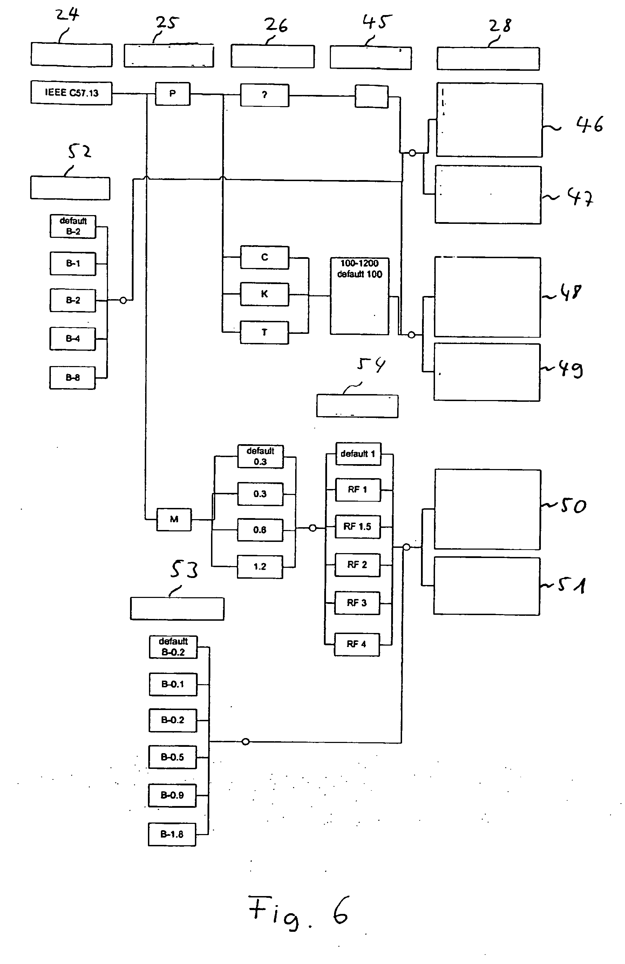

In Fig. 6 ist ein Ablaufdiagramm entsprechend Fig. 4 und 5 zur Vermessung bzw. Bestimmung von Stromwandlern dargestellt, welche nach dem IEEE bzw. ANSI-Standard C57.13 spezifiziert sind. Dabei ist zu beachten, dass in Fig. 6 aus Platzgründen teilweise verschiedene Spalten untereinander dargestellt sind. In Spalte 24 wird dabei wiederum der Standard vorgegeben, in diesem Fall IEEE C57.13. Diesbezüglich ist anzumerken, dass bei einer Vorrichtung, welche zum Prüfen und Bestimmen von Stromwandlern nach den Standards IEC 60044-1, IEC 60044-6 oder IEEE C57.13 ausgelegt ist, die Einstellung des Standards beispielsweise auch über einen Drehschalter erfolgen könnte. In Spalte 25 kann darauf folgend ähnlich wie in Fig. 4 vorgegeben werden, ob es sich um einen Schutzwandler ("P") oder einen Messwandler ("M") handelt. Auch wenn es in Fig. 6 nicht explizit angegeben ist, ist es auch hier prinzipiell denkbar, anzugeben, dass die Art des Stromwandlers nicht bekannt ist und daher automatisch bestimmt werden soll.

In Spalte 26 kann dann eine Klasse des Stromwandlers vorgegeben werden. Für Schutzwandler sieht die ANSI 57.13-Norm Klassen C, K und T vor, wobei Wandler der Klassen C und K einen Streufluss im Kern des Wandlers aufweisen, welcher keinen merklichen Effekt auf das Übersetzungsverhältnis aufweist, während bei Wandlern der Klasse T ein merklicher Effekt vorhanden ist. Wandler der Klasse K erfüllen zudem einen Grenzwert für die Kniespannung. Hier kann auch vorgegeben werden, dass die Klasse nicht bekannt ist ("?"). Für Schutzwandler kann dann in Spalte 45 ein Sekundärklemmenspannungswert eingegeben werden. Dieser Wert gibt im Wesentlichen die Klemmenspannung bei 20-fachem Nennwert des Sekundärstroms bei einer Standardbürde an und wird in dem Standard als "Secondary Terminal Voltage Rating" bezeichnet. Dabei wird ein Übersetzungsfehler von 10% nicht überschritten. Dieser Wert liegt üblicherweise zwischen 100 und 1200, wobei 100 als Default-Wert vorgegeben werden kann. Mittels Soft Keys können typische Werte von 10, 20, 50, 100, 200, 400 und 800 vorgegeben werden.

Zusätzlich kann in Spalte 52 zu einem beliebigen Zeitpunkt der Eingabe die jeweilige Bürde vorgegeben werden, für welche der Wandler ausgelegt wird. Mögliche Bürden bei Schutzwandlern sind im ANSI 57.13-Standard B-1, B-2, B-4 und B-8 bezeichnet, wobei für jede dieser Bürden Werte wie Widerstand, Induktivität etc. vorgegeben sind.

Wiederum entsprechen Blöcke 46 und 47 den Blöcken 29 und 30, wobei nun Kenndaten entsprechend dem ANSI-Standard bestimmt und bewertet werden. Entsprechendes gilt für die Blöcke 48 und 49.

Für Messwandler kann ebenfalls in Spalte 26 die Klasse des Wandlers eingegeben werden. Dabei sind Klassen 0.3, 0.6 und 1.2 definiert, welche jeweils festlegen, wie genau das Übersetzungsverhältnis des Transformators bei einem Nennstrom und bei 10% des Nennstroms eingehalten wird. 0.3 ist dabei die genaueste Klasse, 1.2 die ungenaueste. Als Default-Wert wird 0.3 vorgegeben. In Spalte 45 kann dann ein Nennwert für einen thermischen Stromfaktor eingegeben werden ("Thermal Current Rating Factor"), welcher angibt, um wie viel der Primärstrom größer als der Nennwert des Sekundärstroms sein kann, ohne dass ein merklicher Temperaturanstieg geschieht. Dieser Faktor wird mit RF abgekürzt, mögliche Werte sind 1, 1.5, 2, 3 und 4. Als Default-Wert wird dem Benutzer hier 1 vorgegeben.

Ähnlich wie in Spalte 52 für Schutzwandler kann in Spalte 53 eine Bürde für Messwandler vorgegeben werden. Für Messwandler tragen die im ANSI-Standard definierten Bürden die Bezeichnung B-0.1 bis B-1.8. Als Default-Wert wird dem Benutzer hier B-0.2 vorgegeben. Blöcke 50 und 51 entsprechen dann wiederum Blöcken 29 und 30, wie bei Blöcken 46 bis 49 wird der ANSI-Standard zugrunde gelegt.

Selbstverständlich sind die in Fig. 3-6 dargestellten Flussdiagramme lediglich beispielhaft zu verstehen. In Fig. 3 kann beispielsweise die Reihenfolge der Messung des Kniepunktes bzw. der Anregungskurve und der Messung des Übersetzungsverhältnisses vertauscht werden. Auch müssen natürlich nur diejenigen Parameter gemessen werden, welche zur Bestimmung von gesuchten nominellen Transformatorkenndaten tatsächlich erforderlich sind. In Fig. 4-6 können in den jeweiligen Spalten 28 auch nur ein Teil der gegebenen Werte ausgegeben werden, oder es können noch zusätzliche Messwerte ausgegeben werden. Zudem ist auch für Kenndaten, bei welchen dies nicht explizit durch ein "?" angegeben ist, denkbar, dem Benutzer zu ermöglichen, einzugeben, dass er das jeweilige Transformatorkenndatum nicht kennt. Schließlich sind die oben ausgezeigten Prinzipien auch auf andere Arten von Transformatoren als Stromwandler anwendbar. Weiterhin ist zu bemerken, dass die Messung und Bestimmung der gesuchten Größen nicht erst nach allen Eingaben des Benutzers, d.h. bei Spalte 28 in Fig. 4-6, erfolgen muss. Vielmehr können die zur Bestimmung einer Größe erforderlichen Messungen und Berechnungen auch sofort ausgeführt werden, nachdem der Benutzer eingegeben hat, dass ein bestimmtes abgefragtes Transformatorkenndatum nicht bekannt ist. Schließlich ist anzumerken, dass das erfindungsgemäße Verfahren und die erfindungsgemäße Vorrichtung nicht auf die dargestellten Standards beschränkt sind und insbesondere Weiterentwicklungen dieses Standards berücksichtigt werden können.

Eine Vorrichtung zur Durchführung des erfindungsgemäßen Verfahrens kann zudem Mittel zur Simulation eines Verhaltens eines Transformators bei vorgegebenen Transformatorkenndaten umfassen, um "theoretische" Kurven zu erzeugen.

## Patentansprüche

1. Verfahren zur Bestimmung von nominellen Transformatorkenndaten eines Transformators (8),
wobei mindestens eine elektrische Eigenschaft des Transformators gemessen wird, und
wobei abhängig von der gemessenen mindestens einen elektrischen Eigenschaft ein nominelles Transformatorkenndatum aus einer vorgegebenen Menge von möglichen nominellen Transformatorkenndaten ausgewählt wird.

2. Verfahren nach Anspruch 1,
wobei das nominelle Transformatorkenndatum abhängig von einem Vergleich der mindestens einen gemessenen Eigenschaft mit mindestens einem vorgegebenen Schwellenwert ausgewählt wird.

3. Verfahren nach Anspruch 1 oder 2,
**dadurch gekennzeichnet,**
**dass** das nominelle Transformatorkenndatum in Abhängigkeit von einem Vergleich der gemessenen mindestens einen elektrischen Eigenschaft mit vorgegebenen Transformatorkenndaten und/oder vorgegebenen Normen ausgewählt wird.

4. Verfahren nach einem der vorhergehenden Ansprüche,
**dadurch gekennzeichnet,**
**dass** die mindestens eine elektrische Eigenschaft einen Widerstand einer Sekundärwicklung (8) des Transformators umfasst.

5. Verfahren nach Anspruch 4,
**dadurch gekennzeichnet,**
**dass** abhängig von dem Widerstand der Sekundärwicklung (8) des Transformators ein Nennwert eines Sekundärstroms des Transformators als nominelles Transformatorkenndatum bestimmt wird.

6. Verfahren nach Anspruch 5,
**dadurch gekennzeichnet,**
**dass** der Nennwert des Sekundärstroms in Abhängigkeit von einem Kniepunkt einer Anregungskurve des Transformators und/oder einem Übersetzungsverhältnis des Transformators bestimmt wird.

7. Verfahren nach einem der vorhergehenden Ansprüche,
**dadurch gekennzeichnet,**
**dass** die mindestens eine elektrische Eigenschaft einen Kniepunkt einer Anregungskurve (9) des Transformators umfasst.

8. Verfahren nach Anspruch 7,
**dadurch gekennzeichnet,**
**dass** abhängig von dem Kniepunkt als Transformatorkenndatum ausgewählt wird, ob der Transformator ein Schutzwandler oder ein Messwandler ist.

9. Verfahren nach Anspruch 8,
**dadurch gekennzeichnet,**
**dass** abhängig von einem Übersetzungsverhältnis des Transformators und/oder einem Widerstand einer Sekundärwicklung des Transformators bestimmt wird, ob der Transformator ein Messwandler oder ein Schutzwandler ist.

10. Verfahren nach einem der vorhergehenden Ansprüche,
**dadurch gekennzeichnet,**
**dass** die mindestens eine elektrische Eigenschaft ein Übersetzungsverhältnis des Transformators umfasst.

11. Verfahren nach Anspruch 10,
**dadurch gekennzeichnet,**
**dass** in Abhängigkeit von dem Übersetzungsverhältnis ein Nennwert eines Primärstroms des Transformators, ein Nennwert des Übersetzungsverhältnisses und/oder ein Fehler des Übersetzungsverhältnisses des Transformators als Transformatorkenndaten bestimmt werden.

12. Verfahren nach einem der vorhergehenden Ansprüche,
**dadurch gekennzeichnet,**
**dass** die mindestens eine elektrische Eigenschaft eine Anregungskurve des Transformators, eine Sättigungsinduktivität des Transformators, eine ungesättigte Induktivität des Transformators, eine Hysteresekurve des Transformators und/oder eine Zeitkonstante des Transformators umfasst.

13. Verfahren nach einem der vorhergehenden Ansprüche,
**dadurch gekennzeichnet,**
**dass** Transformatorkenndaten der nominellen Transformatorkenndaten vorgebbar sind, wobei nur nominelle Transformatorkenndaten des Transformators bestimmt werden, welche nicht vorgegeben sind.

14. Verfahren nach Anspruch 13,
**dadurch gekennzeichnet,**
**dass** angezeigt wird, welche nominellen Transformatorkenndaten bestimmt werden und/oder welche Transformatorkenndaten vorgegeben wurden.

15. Verfahren nach einem der vorhergehenden Ansprüche,
**dadurch gekennzeichnet,**
**dass** das Verfahren zur Bestimmung von nominellen Transformatorkenndaten eines Transformators nach IEC 60044-1, IEC 60044-6 oder ANSI C57.13 ausgestaltet ist.

16. Verfahren nach einem der vorhergehenden Ansprüche,
**dadurch gekennzeichnet,**
**dass** mindestens eine weitere elektrische Eigenschaft des Transformators bestimmt und angezeigt wird.

17. Verfahren nach einem der vorhergehenden Ansprüche,
**dadurch gekennzeichnet,**
**dass** der Transformator ein Stromwandler ist.

18. Verfahren nach einem der vorhergehenden Ansprüche,
**dadurch gekennzeichnet,**
**dass** die nominellen Transformatorkenndaten eine Klasse des Transformators umfassen.

19. Vorrichtung zur Bestimmung von nominellen Transformatorkenndaten eines Transformators (8),
mit Messmitteln (2) zur Messung mindestens einer elektrischen Eigenschaft des Transformators (8), und
mit Auswertemitteln (3) zum Auswählen eines nominellen Transformatorkenndatums aus einer vorgegebenen Menge von möglichen nominellen Transformatorkenndaten.

20. Vorrichtung nach Anspruch 19,
**dadurch gekennzeichnet,**
**dass** die Vorrichtung einen Signalgenerator zur Erzeugung von Messsignalen, Steuermittel zur Durchführung der Messung, und/oder Messmittel zur Messung von Strömen oder Spannungen umfasst.

21. Vorrichtung nach Anspruch 19 oder 20,
**dadurch gekennzeichnet,**
**dass** die Messmittel derart ausgestaltet sind, dass Signale zum Messen der mindestens einen elektrischen Eigenschaft elektronisch erzeugt und/oder gemessen werden.

22. Vorrichtung nach einem der Ansprüche 19-21,
**dadurch gekennzeichnet,**
**dass** die Vorrichtung Speichermittel (6) zum Speichern von möglichen nominellen Transformatorkenndaten und/oder Transformatornormen umfasst.

23. Vorrichtung nach einem der Ansprüche 19-22,
**dadurch gekennzeichnet,**
**dass** die Vorrichtung tragbar ausgestaltet ist.

24. Vorrichtung nach einem der Ansprüche 19-23,
**dadurch gekennzeichnet,**
**dass** die Vorrichtung zur Durchführung des Verfahrens nach einem der Ansprüche 1-18 ausgestaltet ist.

25. Computerprogramm-Produkt mit einem Programmcode,
**dadurch gekennzeichnet,**
**dass** bei Ausführung des Programmcodes auf einer Datenverarbeitungsanlage das Verfahren nach einem der Ansprüche 1-18 ausgeführt wird.

## Claims

1. Method for determining nominal transformer key data of a transformer (8), wherein at least one electrical property of the transformer is measured, and wherein depending on the measured at least one electrical property, one nominal transformer key datum is selected from a prespecified quantity of nominal transformer key data.

2. Method according to claim 1, wherein the nominal transformer key datum is selected depending on a comparison of the at least one measured property with at least one prespecified threshold value.

3. Method according to claim 1 or 2, **characterised in that** the nominal transformer key datum is selected depending on a comparison of the measured at least one electrical property with prespecified transformer key data and/or prespecified standards.

4. Method according to any of the preceding claims, **characterised in that** the at least one electrical property comprises a resistance of a secondary winding (8) of the transformer.

5. Method according to claim 4, **characterised in that** depending on the resistance of the secondary winding (8) of the transformer, a nominal value of a secondary current of the transformer is determined as a nominal transformer key datum.

6. Method according to claim 5, **characterised in that** the nominal value of the secondary current is determined depending on a bend point of an excitation curve of the transformer and/or a translation ratio of the transformer.

7. Method according to any of the preceding claims, **characterised in that** the at least one electrical property comprises a bend point of an excitation curve (9) of the transformer.

8. Method according to claim 7, **characterised in that** depending on the bend point, the key datum selected is whether the transformer is a protective converter or a measurement converter.

9. Method according to claim 8, **characterised in that** depending on a translation ratio of the transformer and/or a resistance of a secondary winding of the transformer, it is determined whether the transformer is a measurement converter or a protective converter.

10. Method according to any of the preceding claims, **characterised in that** the at least one electrical property comprises a translation ratio of the transformer.

11. Method according to claim 10, **characterised in that** depending on the translation ratio, the transformer key datum determined is a nominal value of a primary current of the transformer, a nominal value of the translation ratio and/or an error in the translation ratio of the transformer.

12. Method according to any of the preceding claims, **characterised in that** the at least one electrical property comprises an excitation curve of the transformer, a saturation inductance of the transformer, an unsaturated inductance of the transformer, a hysteresis curve of the transformer and/or a time constant of the transformer.

13. Method according to any of the preceding claims, **characterised in that** transformer key data of the nominal transformer key data can be prespecified, wherein only non-prespecified nominal transformer key data of the transformer are determined.

14. Method according to claim 13, **characterised in that** it is shown which nominal transformer key data are determined and/or which transformer key data are prespecified.

15. Method according to any of the preceding claims, **characterised in that** the method for determining nominal transformer key data of a transformer is structured according to IEC 60044-1, IEC 60044-6 or ANSI C57.13.

16. Method according to any of the preceding claims, **characterised in that** at least one further electrical property of the transformer is determined and displayed.

17. Method according to any of the preceding claims, **characterised in that** the transformer is a current converter.

18. Method according to any of the preceding claims, **characterised in that** the nominal transformer key data comprise a class of transformers.

19. Device for determining nominal transformer key data of a transformer (8), with measuring means (2) for measuring at least one electrical property of the transformer (8) and with analysis means (3) for selecting a nominal transformer key datum from a prespecified quantity of possible nominal transformer key data.

20. Device according to claim 19, **characterised in that** the device comprises a signal generator for generating measurement signals, control means for performance of the measurement, and/or measurement means for measuring currents or voltages.

21. Device according to claim 19 or 20, **characterised in that** the measuring means are structured such that signals for measuring at least one electrical property are electronically generated and/or measured.

22. Device according to any of claims 19 - 21, **characterised in that** the device comprises memory means (6) for storing possible nominal transformer key data and/or transformer standards.

23. Device according to any of claims 19 - 22, **characterised in that** the device is designed portable.

24. Device according to any of claims 19 - 23, **characterised in that** the device is designed for performance of the method according to any of claims 1 - 18.

25. Computer program product with a program code, **characterised in that** on execution of the program code on a data processing system, the method according to any of claims 1 - 18 is performed.

## Revendications

1. Procédé de détermination de paramètres nominaux d'un transformateur (8)
dans lequel on mesure au moins une propriété électrique du transformateur, et
en fonction d'au moins une propriété électrique mesurée, un paramètre nominal étant sélectionné à partir d'une quantité donnée de paramètres nominaux possibles d'un transformateur.

2. Procédé selon la revendication 1,
le paramètre nominal du transformateur étant choisi en fonction d'une comparaison d'au moins une propriété mesurée avec au moins une valeur seuil prédéfinie.

3. Procédé selon les revendications 1 ou 2, **caractérisé en ce que**
le paramètre nominal de transformateur est choisi en fonction d'une comparaison d'au moins une propriété électrique mesurée avec des paramètres de transformateur prédéfinis et/ou des normes prédéfinies.

4. Procédé selon l'une des revendications précédentes
**caractérisé en ce que**
au moins une propriété électrique comprend une résistance d'un enroulement secondaire (8) du transformateur.

5. Procédé selon la revendication 4,
**caractérisé en ce que**
en fonction de la résistance de l'enroulement secondaire (8) du transformateur, une valeur nominale d'un courant secondaire du transformateur est déterminée comme paramètre nominal de transformateur.

6. Procédé selon la revendication 5,
**caractérisé en ce que**
la valeur nominale du courant secondaire est déterminée en fonction d'un coude d'une courbe d'excitation du transformateur et/ou d'un rapport de transformation du transformateur.

7. Procédé selon l'une des revendications précédentes,
**caractérisé en ce que**
au moins une propriété électrique comprend un coude d'une courbe d'excitation (9) du transformateur.

8. Procédé selon la revendication 7,
**caractérisé en ce que**
l'on choisit en fonction du coude comme paramètre du transformateur si le transformateur est un transformateur de protection ou un transformateur de mesure.

9. Procédé selon la revendication 8,
**caractérisé en ce que**
en fonction d'un rapport de transformation du transformateur et/ou d'une résistance d'un enroulement secondaire du transformateur on détermine si le transformateur est un transformateur de mesure ou un transformateur de protection.

10. Procédé selon l'une des revendications précédentes
**caractérisé en ce que**
au moins une propriété électrique comprend un rapport de transformation du transformateur.

11. Procédé selon la revendication 10,
**caractérisé en ce que**
en fonction du rapport de transformation une valeur nominale d'un courant primaire du transformateur, une valeur nominale du rapport de transformation et/ou une erreur du rapport de transformation du transformateur sont définies comme paramètres du transformateur.

12. Procédé selon l'une des revendications précédentes,
**caractérisé en ce que**
au moins une propriété électrique comprend une courbe d'excitation du transformateur, une inductance de saturation du transformateur, une inductance non saturée du transformateur, une courbe d'hystérésis du transformateur et/ou une constante de temps du transformateur.

13. Procédé selon l'une des revendications précédentes
**caractérisé en ce que**
des paramètres du transformateur sont définissable comme paramètres nominaux de transformateur, seuls les paramètres nominaux du transformateur étant déterminés, lesquels ne sont pas prédéfinis.

14. Procédé selon la revendication 13,
**caractérisé en ce que**
l'on indique quels paramètres nominaux de transformateur sont déterminés et/ou quels paramètres de transformateur ont été prédéfinis.

15. Procédé selon l'une des revendications précédentes
**caractérisé en ce que**
le procédé de détermination de paramètres nominaux d'un transformateur est configuré selon IEC 60044-1, IEC 60044-6 ou ANSI C57.13.

16. Procédé selon l'une des revendications précédentes
**caractérisé en ce que**
l'on détermine et on indique au moins une autre propriété électrique du transformateur.

17. Procédé selon l'une des revendications précédentes,
**caractérisé en ce que**
le transformateur est un transformateur de courant.

18. Procédé selon l'une des revendications précédentes
**caractérisé en ce que**
les paramètres nominaux de transformateur comprennent une classe du transformateur.

19. Dispositif de détermination des paramètres nominaux d'un transformateur (8)
comprenant des moyens de mesure (2) pour mesurer d'au moins une propriété électrique du transformateur (8) et
comprenant des moyens d'évaluation (3) pour sélectionner un paramètre nominal de transformateur à partir d'une quantité prédéfinie de paramètres nominaux possibles de transformateur.

20. Dispositif selon la revendication 19,
**caractérisé en ce que**
le dispositif comprend un générateur de signaux pour l'émission de signaux de mesure, un moyen de commande pour la réalisation de la mesure et/ou un moyen de mesure pour mesurer des courants ou des tensions.

21. Dispositif selon les revendications 19 ou 20,
**caractérisé en ce que**
les moyens de mesure sont configurés de telle manière que les signaux pour mesurer au moins une propriété électrique sont générés et/ou mesurés électroniquement.

22. Dispositif selon l'une des revendications 19 à 21,
**caractérisé en ce que**
le dispositif comprend un moyen de stockage (6) pour stocker des paramètres nominaux possibles de transformateur et/ou des normes de transformateur.

23. Dispositif selon l'une des revendications 19 à 22,
**caractérisé en ce que**
le dispositif est configuré pour être portatif.

24. Dispositif selon l'une des revendications 19 à 23,
**caractérisé en ce que**
le dispositif est configuré pour la réalisation du procédé selon l'une des revendications 1 à 18.

25. Produit de programmation informatique comportant un code de programme,
**caractérisé en ce que**
lors de l'exécution du code de programme sur une installation de traitement de données, le procédé est réalisé selon l'une des revendications 1 à 18.
